# EUROPÄISCHE PATENTANMELDUNG

(11) **EP 1 835 509 A1**
(43) Veröffentlichungstag der Anmeldung: **19.09.2007**
(21) Anmeldenummer: 07004725.3
(22) Anmeldetag: 08.03.2007
(51) Int. Cl.: G11C 16/02

(54) **Speicherzelle, Speicher mit einer Speicherzelle und Verfahren zum Einschreiben von Daten in eine Speicherzelle**

(30) Priorität: 14.03.2006 DE 102006011688; 14.03.2006 US 375365
(71) Anmelder: Qimonda AG, 81739 München (DE)
(72) Erfinder: Symanczyk, Ralf, Dr., 83104 Tuntenhausen (DE)
(74) Vertreter: Patentanwaltskanzlei WILHELM & BECK

(57) **Zusammenfassung**

Die Erfindung betrifft eine Speicherzelle (1) mit einer programmierbaren Festkörperelektrolytschicht (3), einer Schreibleitung (11) und einem steuerbaren Schalter (14), der zwischen der Festkörperelektrolytschicht und der Schreibleitung angeordnet ist, wobei der steuerbare Schalter einen Steuereingang aufweist, der mit einer Auswahlleitung (9) verbunden ist; der Schalter weist ein Begrenzungselement auf, welches für einen Schreibvorgang einen durch die Festkörperelektrolytschicht fließenden Strom auf eine vorgegebene Menge elektrischer Ladung beschränkt. Ein Speicher mit einem Wortleitungsdecoder (7), einem Bitleitungsdecoder (8), Bitleitungen (11), Wortleitungen (9), Speicherzellen, wobei die Speicherzelle programmierbare Festkörperelektrolytschichten (1) und Transistoren (14) mit schwebenden Gates aufweisen, wobei ein Transistor-Gate mit einer Wortleitung verbunden ist, wobei ein erster Anschluss des Transistors mit der Festkörperelektrolytschicht verbunden ist, wobei ein zweiter Anschluss des Transistors mit einer Bitleitung (11) verbunden ist, wobei die Bitleitungen mit Eingangs-/Ausgangstreibern verbunden sind, wobei das schwebende Gate ein Begrenzungselement ist, das während eines Schreibvorgangs einen durch die Festkörperelektrolytschicht fließenden Strom auf eine vorgegebene Menge elektrischer Ladung durch Erhöhen des Potentials des schwebenden Gates auf einen Wert oberhalb der Spannung auf der Wortleitung begrenzt.

## Beschreibung

Die Ausführungsformen der vorliegenden Erfindung betreffen eine Speicherzelle, einen Speicher mit einer Speicherzelle und ein Verfahren zum Einschreiben von Daten in eine Speicherzelle.

Speicherzellen mit einem Festkörperelektrolytmaterial sind als programmierbare Metallisierungs-Speicherzellen (PMC-Speicherzelle) bekannt. Speichervorrichtungen, die solche PMC-Speicherzellen, sind als CBRAM-Speichervorrichtungen bekannt. Das Speichern unterschiedlicher Zustände in einer PMC-Speicherzelle basiert auf dem Auf- oder Abbau eines leitenden Pfads in dem Elektrolytmaterial zwischen Elektroden, basierend auf einem angelegten elektrischen Feld. Obwohl das Elektrolytmaterial in der Regel einen hohen Widerstand aufweisen kann, kann der leitende Pfad zwischen den Elektroden auf einen niedrigen Widerstand eingestellt werden. So kann die PMC-Speicherzelle je nach Widerstand der PMC-Speicherzelle auf unterschiedliche Zustände eingestellt werden. In der Regel sind beide Zustände der PMC-Speicherzelle hinreichend zeitstabil, so dass die Daten dauerhaft gespeichert werden.

Eine PMC-Speicherzelle wird in der Regel durch Anlegen einer positiven oder einer negativen Spannung an die Festkörperelektrolytschicht betrieben. Um Daten in der PMC-Speicherzelle zu speichern, wird die PMC-Speicherzelle durch Anlegen einer geeigneten Programmierspannung an die PMC-Speicherzelle in den Programmierzustand gebracht, was die Bildung eines leitenden Pfads in dem Festkörperelektrolytmaterial zur Folge hat, welcher der Einstellung eines ersten Zustands mit geringem Widerstand entsprechen kann. Um in der PMC-Speicherzelle einen zweiten Zustand mit hohem Widerstand zu speichern, kann eine Löschspannung so zur Verfügung gestellt werden, dass ein Widerstand der PMC-Speicherzelle auf einen hohen Widerstand zurück wechselt, der dem zweiten Zustand (Löschzustand) entspricht. Zum Auslesen von Daten aus der PMC-Speicherzelle kann eine Lesespannung angelegt werden, die niedriger als die Programmierspannung sein kann. Mit der Lesespannung kann durch den Widerstand der PMC-Speicherzelle ein Strom ermittelt und dem jeweiligen niedrigen oder hohen Widerstandszustand der PMC-Speicherzelle zugeordnet werden.

Das Programmieren der PMC-Speicherzelle hängt vom Strom und der Stromdauer ab. Der Widerstand der PMC-Speicherzelle hängt vom Stromwert und der Stromdauer ab. Daher hängen der Programmierzustand der PMC-Speicherzelle und eine langfristige Stabilität der Funktion der PMC-Speicherzelle vom Schreibverfahren ab.

Daher besteht ein Bedürfnis nach einer verbesserten Speicherzelle, einem verbesserten Speicher und einem verbesserten Verfahren zum Einschreiben von Daten in eine Speicherzelle.

Die Ausführungsformen der vorliegenden Erfindung stellen eine verbesserte Speicherzelle, einen verbesserten Speicher und ein verbessertes Verfahren zum Einschreiben von Daten in eine Speicherzelle zur Verfügung.

Die Ausführungsformen der Erfindung stellen insbesondere eine Speicherzelle mit einem Substrat mit einer programmierbaren Festkörperelektrolytschicht zur Verfügung, die sowohl eine Schreibleitung und einen steuerbaren Schalter aufweist, der zwischen der Festkörperelektrolytschicht und der Schreibleitung angeordnet ist. Die steuerbare Schaltung weist einen Steuereingang, der mit einer Auswahlleitung verbunden ist, auf. Der Schalter umfasst ein Begrenzungselement, das einen durch die Festkörperelektrolytschicht fließenden Strom auf eine vorgegebene Menge elektrischer Ladung für einen Schreibvorgang begrenzt.

Eine weitere Ausführungsform der Erfindung betrifft eine Speicherzelle mit einem Substrat mit einer programmierbaren Festkörperelektrolytschicht, mit einer Schreibleitung, einer Auswahlleitung, einem Transistor mit einer Drain, einer Source und einem schwebenden Gate. Die Source und die Drain des Transistors sind mit der Schreibleitung und mit der Festkörperelektrolytschicht verbunden. Die Elektrolytschicht ist mit einer Potentialquelle verbunden. Das schwebende Transistor-Gate begrenzt einen durch die Festkörperelektrolytschicht fließenden Strom während eines Schreibvorgangs der Festkörperelektrolytschicht.

Eine weitere Ausführungsform der vorliegenden Erfindung betrifft einen Speicher mit einem Wortleitungsdecoder, einem Bitleitungsdecoder, mit Bitleitungen und mit Wortleitungen, die jeweils mit dem Wortleitungsdecoder oder dem Bitleitungsdecoder verbunden sind, mit Speicherzellen, wobei die Speicherzellen programmierbare Festkörperelektrolytschichten und einen steuerbaren Schalter aufweisen, wobei ein Steuereingang des Schalters mit einer Wortleitung verbunden ist, wobei ein erster Anschluss des Schalters mit der Festkörperelektrolytschicht verbunden ist, wobei ein zweiter Anschluss des Schalters mit einer Bitleitung verbunden ist. Die Bitleitungen sind mit Eingangs-/Ausgangstreibern verbunden. Der Schalter weist ein Begrenzungselement auf, das einen während eines Schreibvorgangs durch die Festkörperelektrolytschicht einer Speicherzelle fließenden Strom begrenzt.

Eine weitere Ausführungsform der Erfindung betrifft einen Speicher mit einem Wortleitungsdecoder, einem Bitleitungsdecoder, mit Bitleitungen und mit Wortleitungen, die mit dem Wortleitungsdecoder bzw. mit dem Bitleitungsdecoder verbunden sind. Weiterhin weist der Speicher Speicherzellen auf, wobei die Speicherzellen eine programmierbare Festkörperelektrolytschicht und Transistoren mit schwebenden Gates umfassen. Ein Gate des Transistors ist mit einer Wortleitung verbunden. Ein erster Anschluss des Transistors ist mit der Festkörperelektrolytschicht verbunden. Ein zweiter Anschluss des Transistors ist mit einer Bitleitung verbunden. Die Bitleitungen sind mit Eingangs-/Ausgangstreibern verbunden. Der Transistor mit dem schwebenden Gate begrenzt einen während eines Schreibvorgangs durch die Festkörperelektrolytschicht fließenden Strom.

Eine weitere Ausführungsform der Erfindung betrifft ein Verfahren zum Einschreiben von Daten in eine Speicherzelle, wobei die Speicherzelle eine programmierbare Festkörperelektrolytschicht aufweist. Während eines Schreibvorgangs ist der durch die Festkörperelektrolytschicht fließende Strom auf eine vorgegebene Menge elektrischer Ladung begrenzt. Dadurch kann eine Beschädigung oder eine Beeinträchtigung verhindert werden.

Ein klareres Verständnis der vorliegenden Erfindung ist unter Bezugnahme auf die detaillierte Beschreibung und die Ansprüche im Zusammenhang mit den beigefügten Figuren möglich, wobei in den Figuren gleiche Bezugszeichen ähnliche Elemente betreffen.
Figur 1 zeigt eine programmierbare Festkörperelektrolytschicht;
Figur 2 zeigt ein schematisches Strom-Vorspannungs-Diagramm beim Einschreiben und Löschen von Daten und die programmierbare Festkörperelektrolytschicht;
Figur 3 stellt eine Teilansicht eines Speichers mit einem Speicherelement dar;
Figur 4 zeigt eine Detailansicht des Speicherelements und einer Schreib- und Löschschaltung;
Figur 5 stellt ein Diagramm der Schwellenspannungen auf einer Bitleitung während eines Schreib-, Lösch- und Schreibvorgangs dar;
Figur 6 zeigt die Schwellenwerte einer Wortleitung und eines Stroms auf der Bitleitung als eine Funktion einer Gate-Spannung vor und nach dem Programmieren des schwebenden Gates;
Figur 7 zeigt Diagramme mit Spannungen und Strömen zum Einschreiben von Daten;
Figur 8 stellt Diagramme mit Spannungen und Strömen zum Auslesen von Daten dar; und
Figur 9 zeigt einen Feldeffekttransistor mit einem schwebenden Gate.

Dem Fachmann ist klar, dass die in den Figuren dargestellten Elemente der Vereinfachung und klareren Darstellung dienen, und nicht unbedingt maßstabsgetreu sind. Beispielsweise können die Abmessungen einiger Elemente in den Figuren im Vergleich zu anderen Elementen übertrieben dargestellt sein, um ein besseres Verständnis der Ausführungsformen der vorliegenden Erfindung zu ermöglichen.

### Beschreibung der bevorzugten Ausführungsformen

Die Ausführungsformen der vorliegenden Erfindung können anhand verschiedenster funktionaler Bauteile beschrieben werden. Es wird darauf hingewiesen, dass solche funktionalen Bauteile durch eine Reihe von Hardware-Komponenten und strukturellen Bauteilen realisiert werden können, die zum Ausführen dieser speziellen Funktionen dienen.

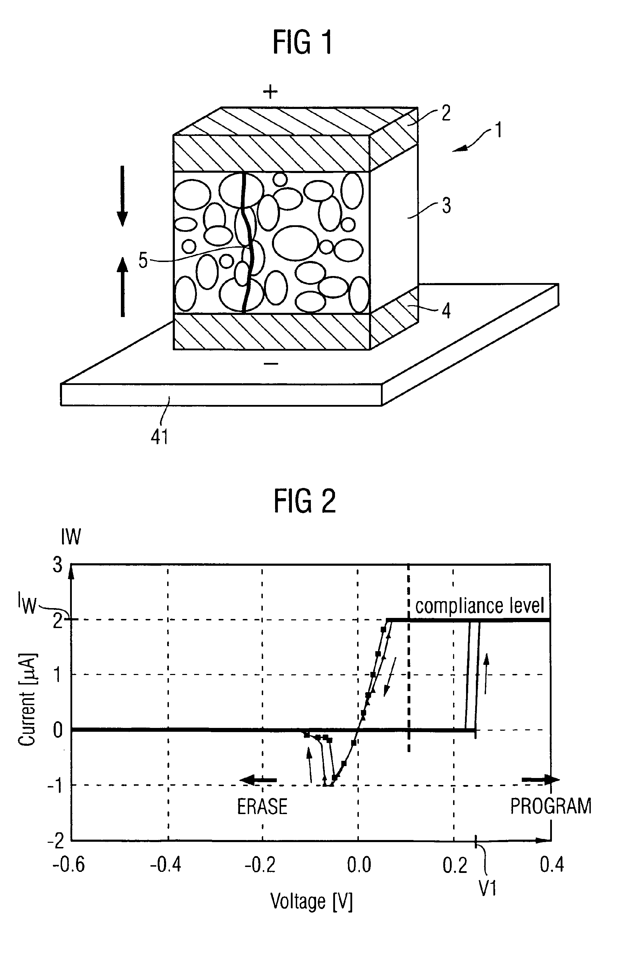

Figur 1 zeigt eine Ausführungsform einer programmierbaren Struktur 1 mit einer ersten Elektrode 2, einer zweiten Elektrode 4 und einer programmierbaren Festkörperelektrolytschicht 3 auf einem Substrat 41. Das Substrat 41 kann aus einem Halbleitermaterial, z.B. aus Silizium, bestehen. Die erste Elektrode 2 kann lösbare metallische Ionen aufweisen und kann in einer Ausführungsform mit einem hohen Potential verbunden sein, z.B. während eines Programmiervorgangs. Die zweite Elektrode 4 kann in dieser Ausführungsform mit einem Massepotential, das geringer als das hohe Potential ist, verbunden sein. In dieser Ausführungsform fungiert die erste Elektrode 2 als Anode und die zweite Elektrode 4 dient als Kathode. Die programmierbare Struktur 1 kann zum Speichern von Informationen verwendet und daher in Speichern eingesetzt werden. In einer Ausführungsform kann die programmierbare Struktur beispielsweise in Speichern, z.B. in einem DRAM-, SRAM-, PROM-, EEPROM-, Flash-Speicher oder einer Kombination aus solchen Speichern eingesetzt werden. Darüber hinaus können in einer Ausführungsform die hierin beschriebenen programmierbaren Strukturen für andere Anwendungen eingesetzt werden, in denen das Programmieren oder das Verändern elektrischer Eigenschaften eines Bereichs einer elektrischen Schaltung erwünscht ist.

In einer Ausführungsform kann die Elektrolytschicht 3 aus einem Material bestehen, welches Ionen nach Anlegen einer ausreichend hohen Spannung leitet. Geeignete Materialien umfassen Polymere, Glas und Halbleitermaterialien. In einer beispielhaften Ausführungsform der Erfindung kann die Elektrolytschicht 3 aus Chalcogenid-Material bestehen, d.h. Sulfid oder Selenid. Das Chalcogenid kann Verbindungen aus Schwefel, Selen und Tellur umfassen, wie z.B. GeSe, AsS, GeAsTe, Al-GeAsTe, GeTeSb und andere in verschiedensten Zusammensetzungen. Die Elektrolytschicht 3 kann außerdem aufgelöste und zerstäubte leitfähige Materialien aufweisen. Beispielsweise kann die Elektrolytschicht 3 eine feste Lösung aufweisen, die aufgelöste Metalle und/oder Metallionen enthält. Das Chalcogenid-Material kann Silber, Kupfer oder Kombinationen aus diesen Materialien enthalten.

In einer Ausführungsform kann die erste Elektrode 2 und die zweite Elektrode 4 aus einem beliebigen geeigneten leitfähigen Material bestehen. Beispielsweise können die erste Elektrode 2 und die zweite Elektrode 4 aus dotiertem Polysiliziummaterial oder Metall gebildet sein. In einer Ausführungsform der vorliegenden Erfindung kann eine der Elektroden, beispielsweise die erste Elektrode 2, aus einem Material bestehen, das ein Metall enthält, welches sich in der Elektrolytschicht 3 auflöst, wenn eine ausreichende Vorspannung an die Elektroden angelegt wird. Die zweite Elektrode 4 kann aus einem Material bestehen, das relativ inert ist und sich eventuell während eines Lese-, eines Schreib- oder eines Löschvorgangs der programmierbaren Struktur 1 nicht auflöst.

Die erste Elektrode 2 kann während eines Schreibvorgangs, der die elektrischen Eigenschaften der programmierbaren Struktur 1 dauerhaft von einem hohen Widerstand (erster Zustand) auf einen niedrigen Widerstand (zweiter Zustand) verändert, eine Anode sein. Die erste Elektrode 2 kann aus einem silberhaltigen Material bestehen, das sich während einem Schreibvorgang in der Elektrolytschicht 3 auflöst. Die zweite Elektrode 4 kann während einem Schreibvorgang eine Kathode sein und aus inertem Material, z.B. aus Wolfram, Nickel, Molybdän, Platin, Metallsilizid und ähnlichem, bestehen.

In einer Ausführungsform kann die programmierbare Struktur so ausgeführt sein, dass bei Anlegen einer Vorspannung, die größer als eine Schwellenspannung V1 ist, an die Elektrode 2, 4, der Widerstand der programmierbaren Struktur verändert wird. Wird beispielsweise eine Spannung angelegt, die größer als die Schwellenspannung V1 ist, können sich leitfähige Ionen der ersten Elektrode 2 in der Elektrolytschicht 3 auflösen und einen leitfähigen Pfad 5 zwischen der ersten und der zweiten Elektrode 2, 4 bilden.

In einer Basisreaktion kann bei Anlegen einer hohen Spannung an die erste Elektrode eine Redoxreaktion an der zweiten Elektrode 4 Metallionen von der reaktiven ersten Elektrode in die Ionenleitschicht 3 treiben. Dadurch kann in der Elektrolytschicht 3 ein leitfähiger Pfad ausgebildet werden. Daraus ergibt sich eine leitende Brücke, die zwischen der ersten und der zweiten Elektrode 2, 4 auftritt und den Widerstand der programmierbaren Struktur 1 verringert. Wenn eine umgekehrte Spannung an die programmierbare Struktur 1 angelegt wird, kann der leitfähige Pfad 5 aufgelöst werden, wodurch der Widerstand der programmierbaren Struktur 1 auf einen hohen Widerstandszustand erhöht wird.

Figur 2 zeigt ein Strom-Spannungs-Diagramm während eines Schreibvorgangs, eines Lesevorgangs und eines Löschvorgangs in der programmierbaren Struktur 1 gemäß einer Ausführungsform der Erfindung. Zu Beginn kann die programmierbare Struktur unprogrammiert sein und daher einen hohen Widerstand aufweisen. Wird eine Spannung mit einem höheren Potential an der ersten Elektrode und einem niedrigeren Potential an der zweiten Elektrode 4 angelegt, kann durch die programmierbare Struktur 1 kein Strom fließen, bis die Schwellenspannung (V1) angelegt wird. Wenn die angelegte Spannung über die Schwellenspannung V1 ansteigt, kann Strom fließen, bis ein Arbeitsstrom IW erreicht ist, und kann von einem Schalter, der in der Figur nicht gezeigt ist, begrenzt werden. In einer Ausführungsform kann die Spannung dann auf 0 Volt reduziert werden, wobei der Strom auf 0 Ampere fällt, wodurch der Schreibvorgang in der programmierbaren Struktur 1 abgeschlossen wird.

In einer Ausführungsform kann zum Löschen des Programmierzustands der programmierbaren Struktur 1 eine niedrige Spannung, z.B. eine negative Spannung (die auch als Löschspannung bezeichnet wird) an die erste Elektrode 2 angelegt werden. Die negative Spannung kann in einer Ausführungsform etwa -0,1 V betragen. Wenn die Löschspannung an die programmierbare Struktur 1 angelegt wird, kann ein negativer Strom durch die programmierbare Struktur 1 fließen. Wenn die negative Spannung unter 0,1 V fällt, hört der Strom zu fließen auf und kann z.B. auf 0 A sinken. Nach dem Anlegen der Löschspannung an die programmierbare Struktur 1 kann die programmierbare Struktur 1 denselben hohen Widerstand wie vor dem Programmiervorgang haben, wodurch die in der programmierbaren Struktur 1 gespeicherten Werte gelöscht werden.

Wenn der Programmierzustand der programmierbaren Struktur 1 abgetastet oder ausgelesen werden soll, kann eine Lesespannung an die programmierbare Struktur 1 angelegt werden, die niedriger als die Schwellenspannung V1 ist. In Abhängigkeit von dem fließenden Strom oder dem Spannungsabfall über der programmierbaren Struktur 1 kann ein niedriger Widerstandswert abgetastet werden, wenn sich der fließende Strom in Bereich des Arbeitsstroms IW befindet. Wenn der fließende Strom beinahe 0 A beträgt, befindet sich die programmierbare Struktur 1 in einem hohen Widerstandszustand. Der niedrige Widerstandszustand kann einem Datum "1" und der hohe Widerstandszustand kann einem Datum "0" entsprechen, das in der programmierbaren Struktur 1 gespeichert ist.

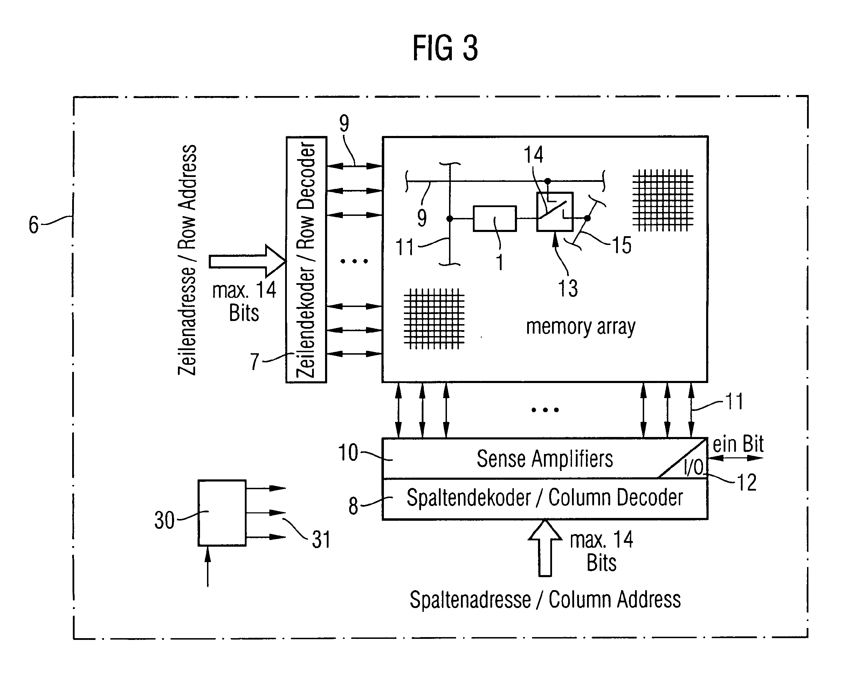

Figur 3 zeigt eine schematische Darstellung eines Speichers, z.B. eines DRAM-Speichers mit einem Wortleitungsdecoder 7 und einem Bitleitungsdecoder 8. Der Wortleitungsdecoder 7 ist mit einer Vielzahl von Wortleitungen 9 verbunden. Der Bitleitungsdecoder 8 ist über Leseverstärker 10 mit Bitleitungen 11 verbunden. Darüber hinaus sind Eingangs-/Ausgangseinheiten 12 vorgesehen, die mit den Bitleitungen verbunden werden können. Die Wortleitungen 9 und die Bitleitungen 11 sind in einem gekreuzten Array angeordnet, wobei an jedem Kreuzungspunkt eine Speicherzelle 13 angebracht ist. Zum Adressieren einer vorgegebenen Speicherzelle 13 wird eine Reihenadresse an den Wortleitungsdecoder 7 weitergeleitet. Darüber hinaus wird eine Spaltenadresse an den Bitleitungsdecoder 8 weitergeleitet. In Abhängigkeit von der Reihenadresse wählt der Wortleitungsdecoder 7 eine der Wortleitungen 9 aus und legt eine Aktivierungsspannung auf die Wortleitung 9. Die Aktivierungsspannung auf der Wortleitung 9 schließt alle Schalter 14, die über einen Steuereingang mit der Wortleitung 9 verbunden sind. Ein geschlossener Schalter 14 verbindet eine Speicherzelle 13 mit einer entsprechenden Bitleitung 11. Darüber hinaus tastet der Leseverstärker 10, der mit der Bitleitung 11 der vorgegebenen Speicherzelle 13 verbunden ist, eine Spannung auf der Bitleitung 11, die vom Widerstandszustand der vorgegebenen Speicherzelle 13 abhängt. Die abgetastete Spannung wird von der Eingangs-/Ausgangseinheit 12 aus dem Speicher 6 als hoher oder als niedriger Spannungspegel ausgegeben.

Eine Steuereinheit 30 ist angeordnet, die Steuerbefehle empfängt und den Wortleitungsdecoder 7, den Bitleitungsdecoder 8 und die Eingangs-/Ausgangseinheiten 12 über die Steuerleitungen 31 steuert.

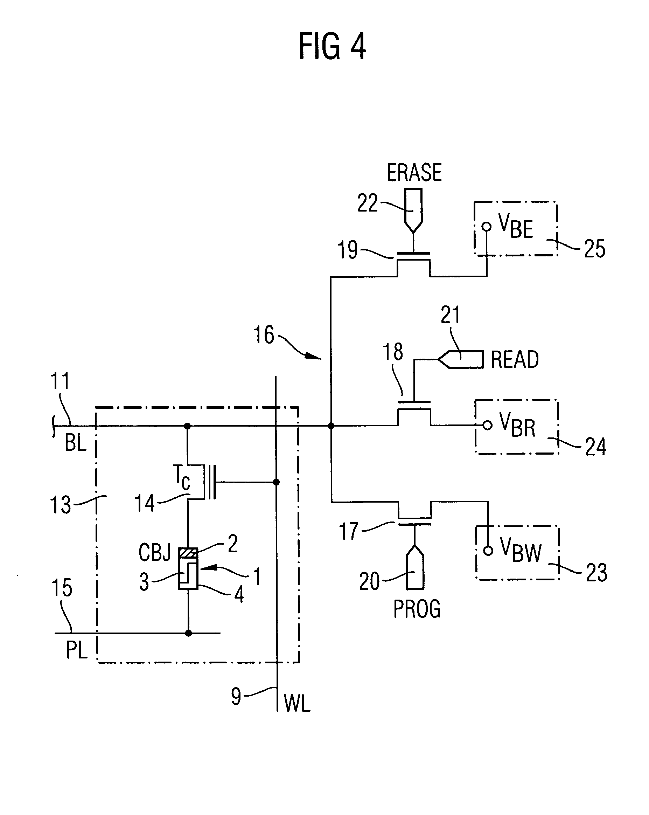

Figur 4 zeigt im Detail einen Teil des Speichers 6 von Figur 3. Am Kreuzungspunkt einer Wortleitung 9 und einer Bitleitung 11 ist die Speicherzelle 13 angeordnet. Die Speicherzelle 13 weist einen Schalter 14 mit einem Steuereingang auf, der mit der Wortleitung 9 verbunden ist. Ein Anschluss des Schalters 14 ist mit der Bitleitung 11 verbunden. Ein weiterer Anschluss des Schalters 14 ist mit einer ersten Elektrode 2 einer Festkörperelektrolytschicht 3 verbunden. Die zweite Elektrode 4 der Festkörperelektrolytschicht 3 ist mit einer Plattenleitung 15 verbunden. Zwischen dem Schalter 14 und der Plattenleitung 15 ist eine programmierbare Struktur 1, wie in Figur 1 gezeigt, angeordnet.

In einer Ausführungsform der vorliegenden Erfindung ist der Schalter 14 ein Feldeffekttransistor mit einem schwebenden Gate. Das Gate des Feldeffekttransistors ist mit der Wortleitung 12 verbunden. Eine Source des Feldeffekttransistors ist mit der Bitleitung 11 und eine Drain des Feldeffekttransistors ist mit der ersten Elektrode 2 der programmierbaren Struktur 1 verbunden.

Je nach Ausführungsform kann die erste Elektrode 2 der programmierbaren Struktur 1 direkt mit der Bitleitung 11 verbunden werden und der Schalter 14 kann zwischen der Plattenleitung 15 und der zweiten Elektrode 4 angeordnet sein.

Eine Programmierschaltung 16, die von der Steuereinheit 30 gesteuert wird, ist mit der Bitleitung 11 verbunden. Die Programmierschaltung 16 weist einen ersten, einen zweiten und einen dritten Schalter 17, 18, 19 auf. Der erste Schalter 17 umfasst einen ersten Steuereingang 20. Der zweite Schalter 18 weist einen zweiten Steuereingang 21 auf. Der dritte Schalter 19 weist einen dritten Steuereingang 22 auf. Der erste Schalter 17 kann als Feldeffekttransistor ausgeführt sein, der mit seiner Source mit einer ersten Potentialquelle und mit seiner Drain mit der Bitleitung 11 verbunden ist. Der zweite Schalter 18 kann als ein Feldeffekttransistor ausgeführt sein, der mit seiner Source mit einer zweiten Potentialquelle 24 und mit seiner Drain mit der Bitleitung 11 verbunden ist. Der dritte Schalter 19 kann als Feldeffekttransistor ausgeführt sein, der mit seiner Source mit einer dritten Potentialquelle 25 und mit seiner Drain mit der Bitleitung 11 verbunden ist. Die Steuereingänge 20, 21, 22 der Schalter 17, 18, 19 sind mit Steuerleitungen 31 verbunden.

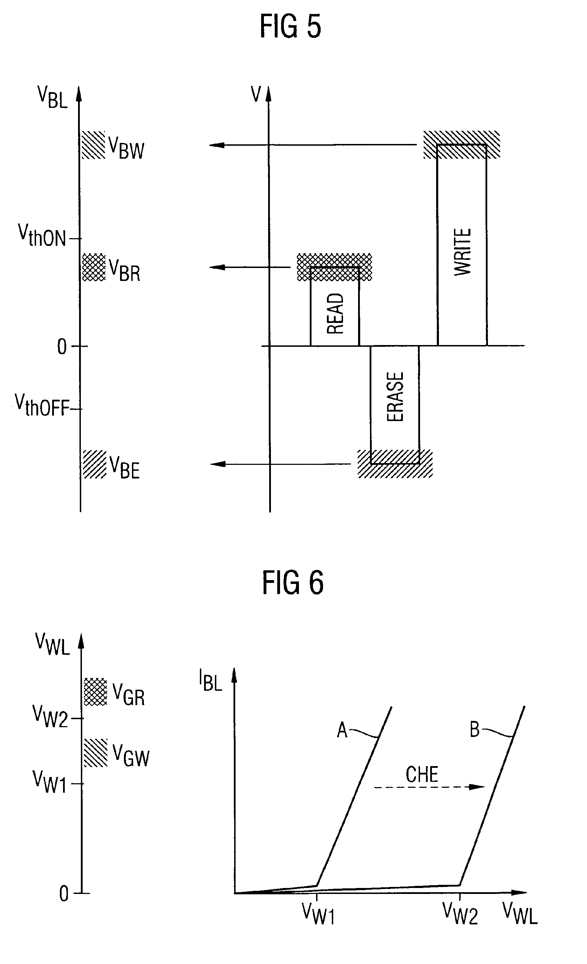

Figur 5 zeigt in einer schematischen Darstellung die Spannungen, die auf die Bitleitung 11 gelegt werden, für einen Lesevorgang, einen Löschvorgang und einen Schreibvorgang. Während eines Schreibvorgangs empfängt die Programmierschaltung 16 ein Programmiersignal durch die Steuereinheit 30 auf dem ersten Steuereingang 20 des ersten Schalters 17, der die erste Potentialquelle 23 mit der Bitleitung 11 verbindet. Der zweite und der dritte Schalter befinden sich in einer offenen Stellung. Daher legt die erste Potentialquelle 23 eine Spannung V_{Bw} auf die Bitleitung 11, die größer ist als die Schwellenspannung V1 der programmierbaren Struktur 1. Deshalb wird während eines Schreibvorgangs die Festkörperelektrolytschicht 3 auf einen niedrigen Widerstandswert programmiert.

Für einen Lesevorgang wird der zweite Schalter 18 durch ein Lesesignal, das von der Steuereinheit 30 an den zweiten Steuereingang 21 weitergeleitet wird, in eine geschlossene Position gebracht. Im geschlossenen Zustand des zweiten Schalters 18 wird die Bitleitung 11 mit der zweiten Potentialquelle 24 verbunden. Der erste und der dritte Schalter 17, 19 befinden sich während des Lesevorgangs in einer offenen Stellung. Die zweite Potentialquelle 24 stellt der Bitleitung 11 eine Lesespannung V_{BR} zur Verfügung, die niedriger als die Schwellenspannung V1 der Festkörperelektrolytschicht 3 ist. Deshalb wird in dieser Stellung der Widerstandswert der programmierbaren Struktur 1 nicht verändert, jedoch kann, in Abhängigkeit von dem durch die programmierbare Struktur 1 fließenden Strom, ein hoher oder ein niedriger Widerstandswert der programmierbaren Struktur von dem Leseverstärker 10 abgetastet werden. In Abhängigkeit von dem ertasteten hohen oder niedrigen Widerstandswert der programmierbaren Struktur 1 gibt die Eingangs-/Ausgangseinheit 12 eine hohe oder eine niedrige Spannung aus.

Während eines Löschvorgangs wird nur der dritte Schalter 19 durch ein Löschsignal, das von der Steuereinheit 30 an den dritten Steuereingang 22 übertragen wird, in eine geschlossene Stellung gebracht. Der erste und der zweite Schalter 17, 18 sind in einer offenen Stellung. Der geschlossene dritte Schalter 19 verbindet die Bitleitung 11 mit der dritten Potentialquelle 25. Die dritte Potentialquelle 25 stellt eine negative Löschspannung V_{BE} zur Verfügung, die niedriger als die Löschspannung der programmierbaren Struktur 1 ist. So wird durch Anlegen der Löschspannung an die programmierbare Struktur 1 der Widerstandswert der Festkörperelektrolytschicht 3 auf einen hohen Widerstandswert geändert.

Figur 6 zeigt eine erste Schwellenspannung V_{W1}, bei der der Feldeffekttransistor mit dem schwebenden Gate in eine geschlossene Stellung gebracht wird. Vor der Auswahl eines vorbestimmten Speicherelements wird die Spannung auf der Wortleitung auf eine Schreibspannung V_{GW} gelegt, die höher ist als die erste Schwellenspannung W1, welche die programmierbare Struktur 1 mit der Bitleitung 11 und der Plattenleitung 15 verbindet. Während des Schreibvorgangs beginnt in dem schwebenden Gate des Feldeffekttransistors eine Injektion heißer Kanalelektronen, und daher steigt, nachdem eine vorgegebene Menge elektrischer Ladung durch die programmierbare Struktur 1 geflossen ist, die Schwellenspannung des Feldeffekttransistors 14 auf eine zweite Schwellenspannung V_{W2}, die höher als die Schreibspannung V_{GW} ist. Daher wird der Feldeffekttransistor 14 in eine offene Position geschaltet, wodurch der durch die Speicherzelle 13 fließende Strom abgeschaltet wird.

Auf der rechten Seite von Figur 6 ist ein zweites Diagramm mit einer ersten Linie A gezeigt, welche den durch den Feldeffekttransistor fließenden Strom I_{BL} in Abhängigkeit von der Spannung auf dem Gate des Feldeffekttransistors darstellt. Der Strom I_{BL} beginnt mit einer ersten Schwellenspannung V_{W1} auf der Wortleitung vor der Injektion heißer Elektronen in das schwebende Gate. Eine zweite Linie B zeigt die veränderte Beziehung zwischen dem Bitleitungsstrom I_{BL} nach den Einspritzen heißer Elektronen in das schwebende Gate. Die Schwellenspannung für den Bitleitungsstrom I_{BL} steigt auf eine zweite Schwellenspannung V_{W2}.

Der Feldeffekttransistor mit dem schwebenden Gate begrenzt den durch die programmierbare Struktur 1 fließenden Strom auf eine vorgegebene Menge elektrischer Ladung. Wenn die vorgegebene Menge elektrischer Ladung durch die programmierbare Struktur 1 geleitet wird, steigt die Schwellenspannung des Feldeffekttransistors über die Schreibspannung der Wortleitung an. Daher wird der Feldeffekttransistor in einen offenen Zustand geschaltet und der durch die programmierbare Struktur 1 fließende Strom endet. Der Feldeffekttransistor mit dem schwebenden Gate ermöglichlicht einen selbstbegrenzenden Schreibvorgang. In Abhängigkeit von dem verwendeten Schreibspannungspegel auf der Wortleitung und den technischen Merkmalen des Feldeffekttransistors mit dem schwebenden Gate können unterschiedliche Mengen elektrischer Ladung bestimmt werden, bei denen der durch die programmierbare Struktur 1 fließende Strom endet. Ein Wiederholen des Schreibvorgangs ist ohne Beschädigung der Speicherzelle 13 möglich, da sich der Feldeffekttransistor immer noch in einem offenen Zustand befindet oder der Strom gemäß der Injektion heißer Kanalelektronen des Feldeffekttransistors nach einer vorgegebenen Menge elektrischer Ladung, die durch die programmierbare Struktur 1 geleitet wird, endet.

Zum Löschen des Zustands der Speicherzelle 13 muss die an die programmierbare Struktur 1 angelegte Spannung umgekehrt werden, wodurch die Funktion von Source und Drain des Feldeffekttransistors verändert wird. Wenn keine Spannung auf dem Gate des Feldeffekttransistors liegt, so bedeutet dies, dass auf das Gate des Feldeffekttransistors das Potential der Plattenleitung 15 wirkt, weshalb der Feldeffekttransistor geschlossen ist und Strom durch die Speicherzelle 13 fließen kann.

In einer weiteren Ausführungsform kann der Schalter mit einem beliebigen anderen Begrenzungselement ausgeführt sein, das den Strom für einen Schreibvorgang auf eine vorgegebene Ladungsmenge begrenzt. Der Schalter kann einen Zeitzähler aufweisen, der den Strom nach einer vorgegebenen Zeitdauer stoppt.

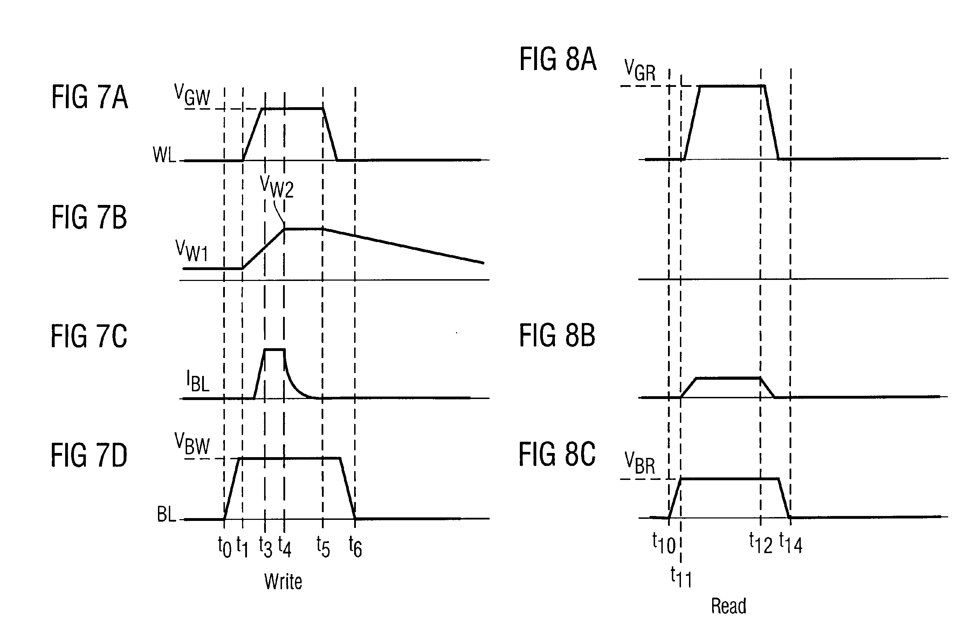

Figur 7 zeigt ein Diagramm für einen Schreibvorgang, wobei in Figur 7A die Spannung auf der Wortleitung, in Figur 7B die Schwellenspannung auf dem Feldeffekttransistor, in Figur 7C der Strom auf der Bitleitung und in Figur 7D die Spannung auf der Bitleitung, jeweils in Abhängigkeit von der Zeit, angezeigt ist. Zu einem Startzeitpunkt t₀ verbindet die Programmierschaltung 16 die Bitleitung 11 mit der ersten Potentialquelle 23 und legt eine Programmierspannung V_{BW} auf die Bitleitung. Zu einem ersten Zeitpunkt t₁ wird die Wortleitung 9 durch den Wortleitungsdecoder 7 mit einer Wortleitungsspannung V_{GW} verbunden, die höher als die Ausgangsschwellenspannung V_{W1} des Feldeffekttransistors 14 ist. Wenn auf der Wortleitung 9 nach dem ersten Zeitpunkt t₁ das Potential ansteigt, steigt auch die Schwellenspannung des Feldeffekttransistors. Darüber hinaus fließt nach dem ersten Zeitpunkt t₁ ein Strom I_{BL} durch die Bitleitung 11 und die Speicherzelle 13. Der durch die Bitleitung 11 fließende Strom I_{BL} steigt zum dritten Zeitpunkt t₃ auf einen begrenzten Maximumwert an. Zum dritten Zeitpunkt t₃ erreicht die Spannung auf der Wortleitung einen maximalen Wert. An einem darauffolgenden Zeitpunkt t₄ erreicht die Schwellenspannung des Feldeffekttransistors einen Maximalwert V_{W2}. Kurz nach dem vierten Zeitpunkt wird der Feldeffekttransistor 14 geöffnet und der durch die Bitleitung 11 fließende Strom fällt aufgrund des Schwebeeffekts des schwebenden Gates des Feldeffekttransistors auf einen Nullwert. Die Schwellenspannung des Feldeffekttransistors steigt über die Spannung auf der Wortleitung an, wodurch der Feldeffekttransistor in einen offenen Zustand geschaltet wird. Zum fünften Zeitpunkt t₅ wird die Wortleitung von der Spannungsquelle getrennt, wodurch es auf der Wortleitung zu einer abfallenden Spannung kommt.

Figur 8 zeigt die Spannung der Wortleitung 9 in Figur 8A, den Strom der Bitleitung in Figur 8B und eine Spannung auf der Bitleitung in Figur 8C für einen Lesevorgang. Zu einem zehnten Zeitpunkt t₁₀ wird die Bitleitung 11 durch den zweiten Schalter 18 mit der zweiten Potentialquelle 24 verbunden und stellt so eine Lesespannung V_{BR} (Figur 8C) zur Verfügung, die niedriger als die Schwellenspannung der Festkörperelektrolytschicht 3 zum Erzeugen eines leitenden Pfads ist. Nach dem Erreichen eines Maximalwerts der Spannung auf der Bitleitung zu einem elften Zeitpunkt t₁₁ wird die Spannung auf der Wortleitung 9 auf eine Lesespannung V_{GR} (Figur 8A) erhöht, die höher als die maximale Schwellenspannung V_{W2} des Feldeffekttransistors nach der Injektion heißer Kanalelektronen ist. Dadurch wird unter allen Umständen das Schließen des Schalters 14 zum Auslesen der gespeicherten Daten aus der Speicherzelle 13 ermöglicht. Wenn ein Datum "1" in der Speicherzelle 13 gespeichert ist, die durch einen geringen Widerstandzustand der programmierbaren Struktur 1 dargestellt wird, fängt nach einem elften Zeitpunkt t₁₁ ein Strom auf der Bitleitung 11 zu fließen an. Anschließend wird die Bitleitung 11 durch den zweiten Schalter 18 von der zweiten Potentialquelle 24 getrennt. Der Strom verursacht eine Spannungsänderung auf der Bitleitung, die von dem Leseverstärker 10 abgetastet werden kann. Zu einem zwölften Zeitpunkt t₁₂ wird die Wortleitung von der Potentialquelle getrennt, wodurch der Schalter 13 gesperrt wird und so die Speicherzelle 13 von der Bitleitung 11 trennt. So sinkt nach dem zwölften Zeitpunkt t₁₂ der durch die Bitleitung fließende Strom auf einen Wert Null.

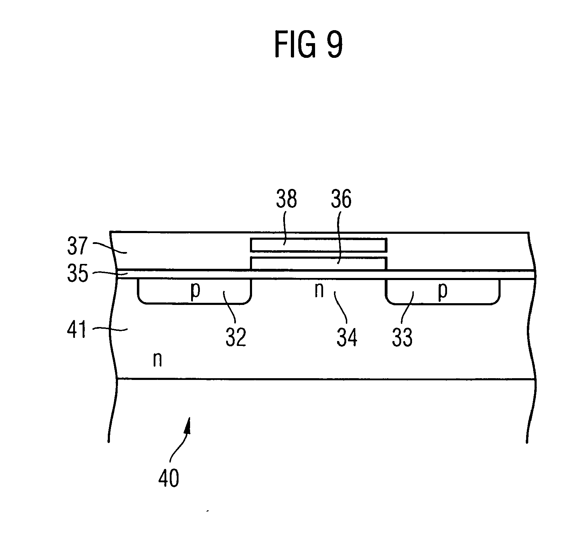

Figur 9 zeigt eine schematische Darstellung eines Feldeffekttransistors 40 mit einer dünnen Isolationsschicht 35 zwischen einem schwebenden Gate 36 und einem Kanal 34, der sich zwischen einer Drain 32 und einer Source 33 befindet, die in einem Halbleitersubstrat 41 angeordnet sind. Das Substrat kann ein n-dotiertes Siliziumsubstrat sein. Die Bereiche von Drain und Source 32, 33 können p-dotiert sein. Oberhalb des schwebenden Gates 36 ist ein Gate-Anschluss 38 angebracht. Der Gate-Anschluss 38 ist von dem schwebenden Gate 36 durch eine zweite Isolationsschicht 37 isoliert. Der Gate-Anschluss ist mit einer Wortleitung 9 verbunden und die heißen Elektronen werden von dem Kanal 34 durch die Isolationsschicht 35 in das schwebende Gate 36 injiziert. Die Dicke der Isolationsschicht 35 zwischen dem Kanal 34 und dem schwebenden Gate 36 kann im Bereich von 4 nm liegen. In einer Ausführungsform der Erfindung kann die Isolationsschicht 35 aus einem Siliziumoxid bestehen. In dieser Ausführungsform kann die Dicke der Oxidschicht im Bereich von weniger als 3 nm liegen. In einer weiteren Ausführungsform kann die Dicke der Oxidschicht im Bereich von 1 bis 2 nm liegen. Durch eine dünne Isolationsschicht wird eine Haltezeit für eine Ladung und für das schwebende Gate verringert. Ein Programmiervorgang kann jedoch schneller durchgeführt werden und die notwendigen Potentiale werden verringert.

### Bezugszeichenliste

- 1: programmierbare Struktur
- 2: erste Elektrode
- 3: Festkörperelektrolytschicht
- 4: Zweite Elektrode
- 5: Leitender Pfad
- 6: Speicher
- 7: Wortleitungsdecoder
- 8: Bitleitungsdecoder
- 9: Wortleitung
- 10: Leseverstärker
- 11: Bitleitung
- 12: Eingangs-/Ausgangseinheit
- 13: Speicherzelle
- 14: Schalter
- 15: Plattenleitung
- 16: Programmierschaltung
- 17: Erster Schalter
- 18: Zweiter Schalter
- 19: Dritter Schalter
- 20: Erster Steuereingang
- 21: Zweiter Steuereingang
- 22: Dritter Steuereingang
- 23: Erste Potentialquelle
- 24: Zweite Potentialquelle
- 25: Dritte Potentialquelle
- 30: Steuereinheit
- 31: Steuerleitung
- 32: Drain
- 33: Source
- 34: Kanal
- 35: Isolationsschicht
- 36: Schwebendes Gate
- 37: Zweite Isolationsschicht
- 38: Gate
- 40: Feldeffekttransistor
- 41: Substrat

## Patentansprüche

1. Speicherzelle mit einer programmierbaren Festkörperelektrolytschicht, einer Schreibleitung und einem steuerbaren Schalter, der zwischen der Festkörperelektrolytschicht und der Schreibleitung angeordnet ist, wobei der steuerbare Schalter einen Steuereingang aufweist, der mit einer Auswahlleitung verbunden ist; wobei der Schalter ein Begrenzungselement aufweist, das einen Strom, der durch Festkörperelektrolytschicht fließt, auf eine vorgegebene elektrische Ladungsmenge für einen Schreibvorgang begrenzt.

2. Speicherzelle mit einer programmierbaren Festkörperelektrolytschicht, einer Schreibleitung, einer Auswahlleitung, mit einem Transistor, der eine Drain, eine Source und ein schwebendes Gate aufweist, wobei der Transistor über die Source und die Drain mit der Schreibleitung und mit der Festkörperelektrolytschicht verbunden ist; wobei die Elektrolytschicht mit einer Potentialquelle verbunden ist; wobei das schwebende Gate des Transistors während eines Schreibvorgangs in der Festkörperelektrolytschicht den durch die Festkörperelektrolytschicht fließenden Strom auf eine vorgegebene elektrische Ladungsmenge begrenzt.

3. Speicherzelle nach Anspruch 2 mit einer Oxidschicht zwischen dem schwebenden Gate und der Festkörperelektrolytschicht, die eine Dicke von weniger als 4 nm aufweist.

4. Speicherzelle nach Anspruch 2 mit einer Oxidschicht zwischen dem schwebenden Gate und der Festkörperelektrolytschicht, die eine Dicke von weniger als 2 nm aufweist.

5. Speicherzelle nach Anspruch 2 mit einem Transistor mit einem schwebenden Gate mit einer Anfangsspannung, die über eine an ein Gate des Transistors angelegte Steuerspannung ansteigt, nachdem eine vorgegebene Strommenge der Festkörperelektrolytschicht zugeführt wurde.

6. Speicher mit einem Wortleitungsdecoder, einem Bitleitungsdecoder, Bitleitungen, Wortleitungen, Speicherzellen, wobei die Speicherzellen programmierbare Festkörperelektrolytschichten und einen steuerbaren Schalter aufweisen, wobei ein Steuereingang des Schalters mit einer Wortleitung verbunden ist, wobei ein erster Anschluss des Schalters mit der Festkörperelektrolytschicht verbunden ist, wobei ein zweiter Anschluss des Schalters mit einer Bitleitung verbunden ist, wobei die Bitleitungen mit Eingangs-/Ausgangstreibern verbunden sind, wobei der Schalter ein Begrenzungselement aufweist, das den durch die Festkörperelektrolytschicht fließenden Strom auf eine vorgegebene elektrische Ladungsmenge für einen Schreibvorgang begrenzt.

7. Speicher mit einem Wortleitungsdecoder, einem Bitleitungsdecoder, Bitleitungen, Wortleitungen, Speicherzellen, wobei die Speicherzellen programmierbare Festkörperelektrolytschichten und Transistoren mit schwebenden Gates aufweisen, wobei ein Gate des Transistors mit einer Wortleitung verbunden ist, wobei ein erster Anschluss des Transistors mit der Festkörperelektrolytschicht verbunden ist, wobei ein zweiter Anschluss des Transistors mit einer Bitleitung verbunden ist, wobei die Bitleitungen mit Eingangs-/Ausgangstreibern verbunden sind, wobei das schwebende Gate ein Begrenzungselement ist, das den durch die Festkörperelektrolytschicht fließenden Strom auf eine vorgegebene elektrische Ladungsmenge durch Erhöhen des Potentials des schwebenden Gates während eines Schreibvorgangs über einer Spannung auf der Wortleitung liegt.

8. Speicher nach Anspruch 7 mit einer Oxidschicht zwischen dem schwebenden Gate und der Festkörperelektrolytschicht, die eine Dicke von weniger als 4 nm aufweist.

9. Speicher nach Anspruch 7 mit einer Oxidschicht zwischen dem schwebenden Gate und der Festkörperelektrolytschicht, die eine Dicke von weniger als 2 nm aufweist.

10. Verfahren zum Einschreiben von Daten in eine Speicherzelle mit einer programmierbaren Festkörperelektrolytschicht, die über einen Schalter mit einer Schreibspannung verbunden ist, wobei während eines Schreibvorgangs Strom durch den Schalter in die Elektrolytschicht fließt und den Widerstand der Elektrolytschicht verändert, wobei der Schalter den durch die Festkörperelektrolytschicht fließenden Strom begrenzt, nachdem eine vorgegebene Ladungsmenge über den Schalter in die Festkörperelektrolytschicht geleitet wurde.

11. Verfahren nach Anspruch 10, wobei der Schalter einen Feldeffekttransistor mit einem schwebenden Gate aufweist, wobei ein Gate des Feldeffekttransistors mit einer Wortleitung verbunden ist, wobei auf die Wortleitung eine Spannung gelegt wird, die während eines Schreibvorgangs den Feldeffekttransistor in einen geschlossenen Zustand steuert, wobei das Potential des schwebenden Gates während eines Schreibvorgangs durch Ladungszuführung auf einen Spannungspegel angehoben wird, der über der Spannung auf der Wortleitung liegt, wodurch der Feldeffekttransistor gesperrt wird.
